# EUROPEAN PATENT APPLICATION

(11) **EP 2 477 072 A1**
(43) Date of publication of application: **18.07.2012**
(21) Application number: 12151428.5
(22) Date of filing: 17.01.2012
(51) Int. Cl.: G03F 1/62

(54) **A pellicle film and a pellicle for EUV application, and a method for manufacturing the film**

(30) Priority: 17.01.2011 JP 2011006652
(71) Applicant: Shin-Etsu Chemical Co., Ltd., Chiyoda-ku, Tokyo 100-0004 (JP)
(72) Inventor: Akiyama, Shoji, Gunma 379-0195 (JP); Kubota, Yoshihiro, Gunma 379-0195 (JP)
(74) Representative: Duckworth, Timothy John

(57) **Abstract**

An EUV pellicle film is provided, which is made from an SOI plate composed of a single crystal silicon membrane of a thickness of 20 nm to 1µm and a handling plate (support structure) for reinforcing the membrane, the handling plate being firmly adhered to the single silicon member via a silicon dioxide layer; the handling plate is etched to have a meshed pattern so as to allow light to pass through the pellicle film.

## Description

### FIELD OF THE INVENTION

The present invention relates to a pellicle for EUV (Extreme Ultra Violet) lithography application, and in particular it relates to a pellicle film for EUV lithography application in which the transparent film consisting of a single crystal silicon membrane having a uniform thickness, and a reinforcement structure are firmly combined with each other without a help of an organic substance or the like; and the invention also concerns a method for manufacturing such a film.

### BACKGROUND OF THE INVENTION

As a result of progresses made in making semiconductor devices in higher densities and smaller sizes, a patterning in a degree of 45 nm or so is being realized. It is possible to deal with this manner of patterning by applying a technology such as immersion lithography or double exposure lithography using ArF, which is an improved technology of conventional technology using an excimer laser. However, with the coming of the next generation technology, wherein the resolution of the patterning is as fine as 32 nm or lower, the exposure lithography based on excimer laser is no longer able to help properly, and an EUV exposure technology, which adopts EUV light whose main wavelength is 13.5 nm - considerably shorter than that of the excimer laser - is considered as the likeliest.

Although a considerable development has been made in the attempt to put the EUV exposure technology into practice, there remain a number of unsolved problems with respect to light source, resist, pellicle, etc. For example, with respect to the dust-fending pellicle, which prevents foreign particles from landing on the photo mask, there are quite a few unsolved problems and those impose a large obstacle against the realization of the EUV exposure lithography.

Of such unsolved problems, more concrete and tough ones are: (1) to develop a material which has a high transmission rate and high chemical stability with respect to EUV light, and (2) to establish a technology to hold a film which is an ultra-thin membrane in a slack-free manner and having a constant tension. Of these, the more concerned problem is that there has been no such material in sight, which not only transmits EUV light at high rate but also is chemically so stable that it scarcely ages by oxidization, etc.

The organic materials that have been used to make conventional pellicle membrane are not transparent to the wavelength of EUV, and as such they are decomposed and degraded by EUV to make the matter worse. There exists no such material as can pass a 100 % of the light of EUV wavelength range; whereas silicon is now in the spot light in that it is relatively transparent to EUV as discussed in literatures (Non-Patent Document 1 and Patent Document 1).

### PRIOR ART DOCUMENTS

Non-Patent Document 1: Shroff et al., "EUV pellicle Development for Mask Defect Control", Emerging Lithographic Technologies X, Proc of SPIE Vol.6151 615104-1(2006) Patent Document 1: Livinson et al., United States Patent 6, 623, 893 B1, "PELLICLE FOR USE IN EUV LITHOGRAPHIY AND METHOD OF MAKING SUCH A PELLICLE"

However, the silicon discussed in the Non-Patent Document 1 is deposited by means of a sputtering method or the like, so that it necessarily becomes non-crystalline and thus absorbs lights of the EUV range with a high rate. In the case of the silicon discussed in the Patent Document 1, it is presupposed that the silicon layer is made by deposition such as CVD method, as is understood from a description of "Can be grown or deposited on ... by semiconductor fabrication techniques, such as, Chemical Vapor Deposition (CVD), Low Temperature (LT) Growth techniques, etc.". Therefore, the silicon is either non-crystalline or poly-crystalline, which has a high light absorption coefficient in the EUV wavelength range.

The silicon membrane bonded on the frame is preferably tensed to some extent; but too much tension would break the membrane, so that it is preferable that the bonding of the silicon membrane is conducted at a room temperature or a little higher than room temperature. However, a defect occurs in that, when a conventional method such as sputtering and CVD is adopted, a strong stress is imparted to the silicon membrane. Also, unlike single crystal silicon, these non-crystalline and polycrystalline siliconmembranes have relatively low densities and are less close that these transparent membranes have high absorption coefficients for EUV light based on the existence of low density non-crystalline sections and grain boundaries; hence they are lower in transmittance than single crystal membrane. Furthermore, since they are chemically less stable, they undergo oxidation easily and their EUV light transmittances are lowered with time, therefore, they cannot stand practical use.

Thus, it is desirous that the transparent membrane is made of single crystal silicon, and it is important that this single crystal silicon membrane has a uniform thickness from end to end so as to exhibit uniform transmittance. Also, another important point about an EUV pellicle is that it is expected that the membrane thickness is required to be from several tens of nanometers to 100 nm or so. Therefore, it is a difficult thing to support the membrane on a conventional frame. Hence, it is necessary to support the thin silicon membrane by means of a reinforcement structure (e.g., honeycomb structure) having a thickness of several hundreds of micrometers, which extends allover the entire pellicle membrane (aforementioned Non-Patent Document 1). This reinforcement structure shall be so positioned that the EUV exposure light does not focus upon it, and therefore it does not cast its shadow on the wafer.

However, unless this reinforcement structure (honeycomb) and the silicon membrane are firmly bound together, the two may part from each other during light exposure, and as a result the membrane may be broken. Therefore, it is extremely important that the membrane and the reinforcement structure are bound together strongly. However, as the EUV light exposure is carried out in a vacuum atmosphere, an adhesive agent made of organic substances cannot be used. Therefore, it is required that inorganically firm bonding is achieved.

### SUMMARY OF THE INVENTION

### PROBLEMS TO BE SOLVED BY THE INVENTION

Therefore, the first object of the present invention is to provide a pellicle film for EUV comprising a single crystal silicon membrane having a uniform thickness, and a reinforcement structure, wherein the saidmembrane and reinforcement structure are firmly combined together without using an organic substance or the like.
The second object of the present invention is to provide a pellicle for EUV wherein the pellicle membrane is consisting of a single crystal silicon membrane having a uniform thickness.
The third object of the present invention is to provide a method for manufacturing a transparent film for pellicle wherein a single crystal silicon membrane having a uniform thickness and a reinforcement structure which are firmly combined together without using an organic substance or the like.

As a result of extensive studies with respect to (1) making a pellicle membrane having uniform thickness from single crystal silicon, and (2) mechanically reinforcing the fragile and extremely thin pellicle membrane in order to attain the above objects, the inventors of the present invention found that it was possible to attain the objects by adopting a single crystal silicon (SOI) plate as the starting material, using the SOI silicon layer (single crystal silicon layer) as the optically transparent membrane, and making a handle plate of the SOI, which inherently belongs to the SOI plate, into the reinforcement structure, thereby achieving the present invention.

### MEANS TO SOLVE THE PROBLEM

Namely, the present inventions are a pellicle film **characterized in that** the said pellicle film consists of a single crystal silicon membrane of a thickness of 20 nm to 1µm and a support structure for reinforcing the said membrane, wherein the single crystal silicon membrane and the support structure are firmly coupled together by means of a silicon oxide layer, a pellicle for EUV using the said pellicle film and a method for manufacturing the said pellicle film.

In the present invention, the thickness of the silicon oxide layer is preferably 20 nm - 1µm, and it is also preferable to use, in the manufacturing process thereof, a single crystal silicon wafer in which the silicon oxide film layer, called as BOX (buried oxide), has a thickness of 20 nm - 1µm.

### EFFECTS OF THE INVENTION

The pellicle for EUV of the present invention has a single crystal silicon layer having a uniform thickness as the pellicle membrane, and it has excellent transmittance for the light of EUVregion, furthermore, it has sufficient strength for practical use owing to having the support structure. In addition, since the starting material is the single crystal silicon wafer, the yield ratio of the pellicle is good and the manufacturing economy is also good.

### BRIEF DESCRIPTION OF DRAWING

Fig. 1 is an explanatory drawing to show the steps for manufacturing a pellicle film of the present invention.
Fig. 2 is a drawing corresponding to the photographically recorded pellicle film of the present invention observed through an optical microscope.

### BEST MODES FOR CARRYING OUT THE INVENTION

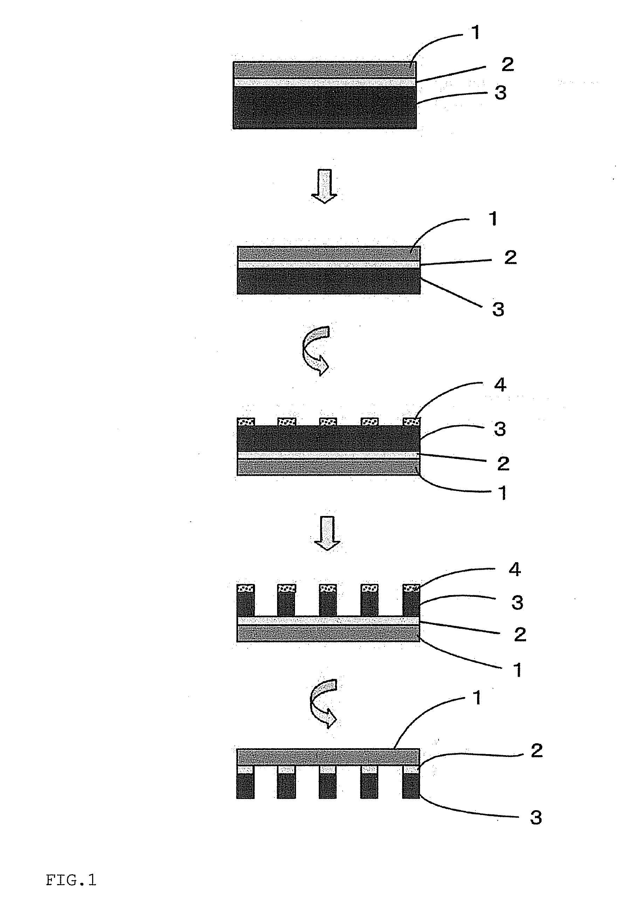

The pellicle filmof the present invention is a single crystal silicon layer supported by a support structure, and a silicon oxide layer exists between the support structure and the single crystal silicon layer, therefore, a three-layer structure consisting of the single crystal silicon layer, silicon oxide layer and the support structure is formed at the part where the support structure (e.g. honeycomb structure) exists; on the other hand, the part of the film where the support structure is absent is consisting of a single layer membrane of the crystal silicon layer only(See Fig. 1).

The thickness of the above-mentioned single crystal silicon layer is required to be 20 nm - 1µm from the viewpoints of optical transmissivity and mechanical strength or the like in order to be used as a pellicle. The thickness of the silicon oxide layer influences the yield ratio when the pellicle film is manufactured, as described later, and this also is preferred to be 20 nm - 1µm. Also, each of these three layers ought to be firmly bound to the each adjacent layer. For these reasons, in the present invention, it is preferable to use a single crystal silicon substrate (hereinafter this substrate is referred to as "SOI plate") as the starting material, wherein a silicon wafer having a silicon oxide layer called BOX (Buried oxide) layer immediately underneath a single crystal silicon layer is provided on a support layer (handle plate).

In other words, by using a properly selected SOI plate as the starting material, in which a silicon wafer is bonded onto a handle plate, it is possible to obtain a strongly bonded uniform combination of the single crystal silicon membrane and the support structure (e.g., honeycomb). The SOI wafer is **characterized in that** an oxide layer called BOX (buried oxide) layer is provided immediately underneath a single crystal silicon layer, and in order to use this for EUV pellicle, it is preferable that, as mentioned above in connection with the silicon oxide layer, the BOX layer has a thickness of 20 nm - 1µm.

Also, in the case in which the SOI plate is used as the starting material, it is possible to convert the support plate (handle plate), which is inherent in the silicon wafer of the SOI plate, as the support structure. In other words, it is possible, for example, to etch the handle plate into a honeycomb structure or the like. In this case, the Box layer functions as an etching stopper layer so that the finished pellicle film will inherit substantially the original uniformity in the thickness of the single crystal silicon layer from the starting SOI plate. Also, as the superfluous portions of the BOX layer are not needed, they can be removed by being dissolved with hydrogen fluoride (HF) or the like (See Fig. 1).

The pellicle film thus obtained was originally a single body SOI plate consisting of a single crystal silicon layer, a silicon oxide layer and a support plate. Therefore, the original strong consolidation of the multi-layer body is inherited, and the single body structure consisting of the silicon membrane and the support structure (e.g., honeycomb structure), which are strongly bonded together via the silicon oxide layer, is obtained.

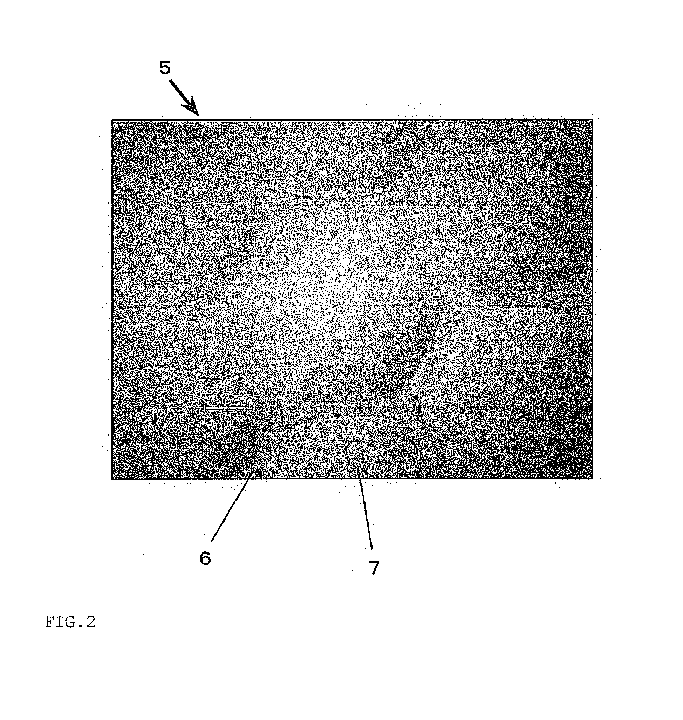

The thus obtained pellicle film of the present invention is **characterized in that** it has the silicon oxide layer between the single crystal silicon membrane and the support structure, on the other hand, not only the silicon oxide layer but also the support structure do not exist at the part where the light transmits. Fig. 2 is a drawing corresponding to a microscopically taken photograph of a finished pellicle film. Reference numeral 6 designates a part of the surface of a pellicle membrane that is backed by a support structure and 7 designates a part of the surface of the pellicle membrane that is not backed by a support structure. A pellicle made in any conventional manner using this pellicle film is the pellicle for EUV of the present invention.

Next will be described a method for manufacturing the pellicle film of the present invention.
In the present invention an SOI (silicon on insulator) plate is used as the starting plate. This plate, typically, is an SOI plate having a diameter of 200 mm, and it is recommended to use an SOI plate whose handle plate has already been thinned, because of the fact that the thickness of the finished film will substantially be the height (thickness) of the support structure (honeycomb). However, of course, it is possible to use an SOI plate with a usual handle plate and to thin it later by etching, etc..

In this thin SOI plate, a honeycomb structure is created by etching. On this occasion the etching is so controlled that the handle plate is turned into a honeycomb structured plate. The superfluous portions of the BOX film is removed by HF, and the both faces of the transmissive membrane are exposed, and the pellicle film of the present invention is completed. It is noted that the silicon dioxide layer remains between the honeycomb structure and the single crystal silicon membrane (ref. Fig. 1).

A problem with this method for manufacturing the pellicle film is the thickness of the BOX layer. If the BOX layer is too thick, for one thing, the time consumed by its removal with HF becomes too long, and for another, during this lengthy time period, the HF may penetrate into the non-superfluous portions of the BOX layer and may cause inadvertent separation of the single crystal silicon membrane from the honeycomb. On the other hand, if the BOX layer is too thin, it may fail to function as the etching stopper layer, itself being etched through. The inventors repeated experiments in order to solve this problem and came to a conclusion that the optimum range for the BOX layer thickness is 20 nm - 1µm.

### EXAMPLES

We will describe the present invention with reference to its examples; however, one should not consider that the examples defining the present invention. It is noted that the thickness of each layer was measured by means of a film thickness measurement apparatus of optical interferometer type.

### Example 1

As the starting plate, an SOI (Silicon On Insulator) plate consisting of successively a handle plate of 200 mm diameter and 725 µm thickness, a 150 nm thick thermally grown silicon oxide (SiO₂) layer and a 100 nm thick thin layer of silicon single crystal (Nearly Perfect Crystal: NPC) was used. The handle plate is a silicon plate and the silicon single crystal does not substantially contain any crystal defects such as COP (Crystal Originated Particle: void defect).

First, the handle plate portion of the SOI plate was thinned to 300µm; next, the handle plate was patterned to have a mesh pattern 4 by lithography, then dry-etching was carried out to have a mesh structure. After that, the exposed portions of the BOX layer (silicon oxide layer) were removed by using HF to complete a pellicle film (see Fig. 1).

### Example 2

As the starting plate, an SOI (Silicon On Insulator) plate consisting of successively a handle plate of 200 mm diameter and 725 µm thickness, a 10 nm thick thermally grown silicon oxide (SiO₂) layer and a 100 nm thick thin layer of silicon single crystal (Nearly Perfect Crystal: NPC) was used. The handle plate is a silicon plate and the silicon single crystal does not substantially contain any crystal defects such as COP.

The aforementioned handle plate portion of the SOI plate was thinned to 30µm. The handle plate was patterned to have a mesh pattern by lithography, then, dry-etching was carried out to have a mesh structure. After that, the exposed portions of the BOX oxide layer were removed by using HF to complete a pellicle film.

### Example 3

As the starting plate, an SOI (Silicon On Insulator) plate consisting of successively a handle plate of 200 mm diameter and 725 µm thickness, a 1µm thick thermally grown silicon oxide (SiO₂) layer and a 100 nm thick thin layer of silicon single crystal (Nearly Perfect Crystal) was used. The handle plate is a silicon plate and the single crystal silicon does not substantially contain any crystal defects such as COP.

The handle plate was patterned to have a mesh pattern by lithography, then, dry-etching was carried out to have a mesh structure. After that, the exposed portions of the BOX oxide layer were removed by using HF to complete a pellicle film.

### Comparative Example 1

As the starting plate, an SOI (Silicon On Insulator) plate consisting of successively a handle plate of 200 mm diameter and 725 µm thickness, a 10 nm thick thermally grown silicon oxide (SiO₂) layer and a 100 nm thick thin layer of silicon single crystal (Nearly Perfect Crystal: NPC) was used. The handle plate is a silicon plate and the silicon single crystal does not substantially contain any crystal defects such as COP.

The aforementioned handle plate portion of the SOI plate was thinned to 20µm. The handle plate was patterned to have a mesh pattern by lithography, then, dry-etching was carried out to have a mesh structure. However, there was an area where the BOX layer was completely etched and the silicon single crystal membrane of that area was also etched and disappeared.

### Comparative Example 2

As the starting plate, an SOI (Silicon On Insulator) plate consisting of successively a handle plate of 200 mm diameter and 725 µm thickness, a 1.2µm thick thermally grown silicon oxide (SiO₂) layer and a 100 nm thick thin layer of silicon single crystal (Nearly Perfect Crystal: NPC) was used. The handle plate is a silicon plate and the silicon single crystal does not substantially contain any crystal defects such as COP.

The handle plate was patterned to have a mesh pattern by lithography, then, dry-etching was carried out to have a mesh structure. Then, the exposed portions of the BOX oxide layer were removed by using HF. After this process, it is observed that some portions of BOX layer which exists between the membrane of silicon single crystal and honeycomb were etched off to result the separation of the membrane of silicon single crystal from honeycomb.

### INDUSTRIAL AVAILABILITY

The pellicle for EUV of the present invention can be used in the EUV light exposure lithographic technology, which is considered the next generation technology, wherein the EUV light whose main wavelength of 13.5 nm is considerably shorter than that of the excimer laser light; hence the present invention is industrially very useful.

### DESIGNATION OF THE REFERENCE NUMERALS

1 Single crystal silicon layer
2 Silicon oxide layer
3 Handle plate
4 Masking resin
5 Surface of pellicle membrane
6 A drawing corresponding to a photograph of the surface of pellicle membrane having a support structure in backside
7 A drawing corresponding to a photograph of the surface of pellicle membrane having no support structure in backside

## Claims

1. A pellicle film comprising a single crystal silicon membrane of a thickness of 20 nm to 1 µm and a support structure for reinforcing the membrane, wherein the single crystal silicon membrane and the support structure are firmly combined with each other by means of a silicon oxide layer.

2. A pellicle film as claimed in claim 1, wherein the thickness of the silicon oxide layer is 20 nm to 1µm.

3. A method for manufacturing a pellicle film comprising the steps of:
(i) preparing an SOI (Silicon on Insulator) plate comprising a single crystal silicon layer, a silicon oxide layer and a silicon handling plate, wherein the thicknesses of the single crystal layer and the silicon oxide layer are 20 nm to 1 µm, respectively, and the thickness of the silicon handling plate is 30 - 300 µm;
(ii) forming a masking pattern which corresponds to a support structure, on the silicon handling plate;
(iii) making the silicon handling plate into the support structure by carrying out a dry-etching until the silicon oxide layer is exposed; and
(iv) removing the exposed silicon oxide layer.

4. A method as claimed in claim 3 wherein the step (iv) comprises dissolving the silicon oxide layer by using HF.

5. A pellicle film comprising a single crystal silicon membrane of a thickness of 20 nm to 1 µm and a support structure for reinforcing the membrane which is obtainable by a method as defined in claim 3 or 4.

6. A pellicle for EUV comprising the pellicle film defined in claim 1, 2 or 5.
